# FASCICULE DE BREVET EUROPEEN

(11) **EP 2 765 575 B1**
(45) Date de publication et mention de la délivrance du brevet: **12.12.2018**
(21) Numéro de dépôt: 14154343.9
(22) Date de dépôt: 07.02.2014
(51) Int. Cl.: G11C 13/00

(54) **Méthode de programmation d'une mémoire résistive non volatile**
Programmierungsverfahren eines nicht flüchtigen, resistiven Speichers
Method for programming a non-volatile resistive memory

(30) Priorité: 08.02.2013 FR 1351093
(43) Date de publication de la demande: 13.08.2014
(73) Titulaire: COMMISSARIAT À L'ÉNERGIE ATOMIQUE ET AUX ÉNERGIES ALTERNATIVES, 75015 Paris (FR)
(72) Inventeur: Perniola, Luca, 38360 Noyarey (FR)
(74) Mandataire: Hautier, Nicolas

(56) Documents cités:
- EP-A1- 2 402 953
- WO-A1-2007/141865
- US-A1- 2012 081 946

## Description

### DOMAINE TECHNIQUE DE L'INVENTION

La présente invention concerne, en général, les mémoires résistives non volatiles, et plus particulièrement, les mémoires résistives pouvant être utilisée dans le cadre d'un processus industriel de fabrication de systèmes embarqués où il est très avantageux de pouvoir les préprogrammer dans leur environnement de fabrication sans que les informations stockées puissent être ensuite perdues en raison des contraintes thermiques subies, notamment celles d'assemblage comprenant des étapes de soudage ou de brasage par refusion des composants. L'invention porte notamment sur un procédé de programmation de cellules mémoire résistives et un procédé de fabrication d'un composant électronique comprenant une matrice de cellules mémoire résistives.

### ÉTAT DE LA TECHNIQUE

Les systèmes embarqués informatisés font toujours très largement appel, en plus des éléments électroniques, optiques ou mécaniques propres à chaque système, à l'utilisation de microprocesseurs ou de microcontrôleurs et aux mémoires électroniques nécessaires pour assurer leur fonctionnement. Typiquement, tous les composants constituant un système embarqué sont assemblés sur un ou plusieurs circuits imprimés ou cartes électroniques souvent aussi désignés par leur vocable anglais de PCB, c'est-à-dire « printed circuit board ». L'assemblage est généralement automatisé dans une chaîne de fabrication. Les composants électroniques se présentent le plus souvent sous la forme de composants destinés à être montés en surface (sans broches traversantes). Ils sont alors simplement posés sur le circuit imprimé par une machine de placement. Préalablement, un dépôt d'une pâte de soudage ou de brasage sur les terminaisons des composants et/ou celles du circuit imprimés aura été effectué. On fait ensuite passer le circuit imprimé sur lequel les composants ont été placés dans un four de chauffage, typiquement un four dit tunnel où le gradient de température est réglé pour faire fondre la pâte déposée qui assure, après refroidissement, une fixation mécanique des composants et un excellent contact électrique. Cette opération standard de fabrication d'un circuit imprimé est qualifiée de soudage ou brasage par refusion ou encore, dans la littérature technique en anglais, de « solder reflow ».

Presque toujours, une partie au moins des mémoires constituant un système embarqué est de type non volatile. Par exemple, pour pouvoir y stocker de façon permanente le code opérationnel, généralement appelé microcode, du ou des microprocesseurs ou microcontrôleurs qui servent à réaliser la fonction pour laquelle le système embarqué a été conçu. Il est alors de pratique courante que le processus de fabrication demande que la partie non volatile des mémoires puisse être programmée avant leur montage sur le circuit imprimé. Un avantage très important de cette façon de faire est qu'on peut alors, par exemple, préprogrammer dans la partie non volatile un code spécifique destiné à tester le circuit imprimé dès après assemblage de façon à vérifier son intégrité. Un autre exemple d'avantage lié à la possibilité de pouvoir préprogrammer les mémoires non volatiles concerne les cartes à puce sécurisées souvent désignées par leur vocable anglais de « secure smart cards ». Les émetteurs de telles cartes, par exemple les banques, préfèrent de beaucoup que les données confidentielles qu'elles contiennent puissent y être introduites avant assemblage afin de ne pas avoir à contrôler la distribution de ces informations sensibles au-delà de la chaîne de fabrication.

Si le code opérationnel ou les données fonctionnelles que doivent contenir une mémoire non volatile n'ont pas été préprogrammés ils devront alors pouvoir être chargés in situ, c'est-à-dire dans la mémoire non volatile après qu'elle a été assemblée et interconnectée avec les autres composants sur le circuit imprimé. Des moyens ont été développés depuis longtemps par l'industrie de la microélectronique pour assurer cette fonction après assemblage. Une pratique courante est d'utiliser les circuits de tests qui sont contenus dans la quasi-totalité des circuits développés par cette industrie notamment les circuits dits JTAG, acronyme de l'anglais « Joint Test Action Group » qui désigne un groupe de travail qui a permis de définir une stratégie et des moyens de test des circuits imprimés dès le milieu des années 80 afin de pouvoir s'assurer, après fabrication, du bon fonctionnement de circuits de plus en plus complexes. Devenu un standard, les circuits JTAG permettent d'accéder individuellement aux composants assemblés sur un circuit imprimé à travers une interface série spécialisée qui peut aussi permettre une programmation in situ de la partie mémoire non volatile. La vitesse d'accès intrinsèquement faible et la bande passante disponible limitée de cette méthode font que le chargement du code est une opération qui peut prendre beaucoup de temps et ralentir la chaîne de fabrication.

D'autres moyens ont été conçus pour la programmation in situ de la partie non volatile des mémoires qui ont leurs propres inconvénients comme de nécessiter des points de connexion spécialisés qui n'auront aucune utilité fonctionnelle et/où une interface dédiée à cette fonction pour permettre d'une part, l'écriture du code dans la partie mémoire non volatile, et d'autre part, le contrôle des autres composants afin qu'ils puissent être inhibés pour ne pas interférer avec le chargement du code. Ceci ne manque pas de compliquer grandement la conception du système embarqué et nécessite aussi généralement le développement d'un outil de programmation spécialisé pour le chargement du code après assemblage dans la ligne de fabrication.

Chaque fois que c'est possible on préfère donc charger tout le code nécessaire, c'est-à-dire non seulement le code de test mais aussi le code fonctionnel, avant assemblage. Ceci évite d'avoir recours à une programmation in situ avec tous les inconvénients brièvement mentionnés ci-dessus.

Les mémoires non volatiles utilisées actuellement sont essentiellement des mémoires dites Flash dans lesquelles chaque point mémoire est un transistor métal-oxyde-semiconducteur (MOS) possédant une grille flottante dans lequel on piège des porteurs. La programmation de ces mémoires se fait en appliquant sur les électrodes des tensions plus élevées que celles utilisées pour leur lecture. Ces tensions permettent d'amener dans la grille flottante des charges, ou à les évacuer, afin de modifier de façon permanente, en lecture, le seuil de conduction du transistor pour pouvoir y stocker au moins deux niveaux électriques différents c'est-à-dire un bit d'information. Le piégeage et l'évacuation des porteurs se fait à travers la couche d'oxyde très mince formant la grille du transistor MOS en mettant en oeuvre des effets quantiques du type effet tunnel ou électron chaud. Ce type de stockage non volatile n'est pas particulièrement affecté par la température. Les mémoires Flash supportent très bien la programmation avant assemblage. Leur contenu n'est pas altéré par l'opération de soudage par refusion décrite précédemment dans laquelle, typiquement, la température maximum atteinte est de l'ordre de 245°C pour les pâtes de soudage contenant du plomb. L'emploi de pâtes sans plomb, maintenant requis pour leur caractère non polluant, augmente la température jusqu'à 260° C voire plus, ce qui reste sans effet négatif sur la rétention des données préprogrammées dans ce type de mémoire. L'inconvénient principal des mémoires Flash est que leur programmation nécessite, comme on l'a vu ci-dessus, de devoir appliquer des tensions et courants importants pour transférer des charges dans ou depuis la grille flottante. Leur écriture est une opération relativement lente et compliquée qui peut avoir à se faire, en fonction de leur structure interne de type dit ET ou OU, sur des blocks de cellules qui doivent être effacés avant d'être réécrits avec les nouvelles données.

Il existe par ailleurs d'autres types de mémoires désignées cellules mémoire à changement de phase. Les documents WO-2007-141865 et EP-2-402-953 concernent notamment l'insertion, entre les électrodes formant la cellule mémoire, d'une couche formée en un matériau à changement de phase de type chalcogénure. Le document WO-2007-141865 décrit un procédé de préprogrammation d'une telle cellule, ce procédé de préprogrammation comprenant les étapes énoncées en préambule de la revendication 1 du procédé selon la présente invention.

Dans ces dispositifs, pour faire passer le chalcogénure d'un état cristallin à un état amorphe, il est nécessaire d'apporter au chalcogénure de la chaleur, dans une plage de température restreinte, afin d'engendrer une commutation de la cellule mémoire d'un état (par exemple, SET) à un autre état (par exemple, RESET).

C'est pourquoi les concepteurs de systèmes embarqués se tournent maintenant vers l'emploi d'autres types de mémoires non volatiles qui ne présentent pas ces inconvénients. Il s'agit notamment des mémoires dites « résistives » globalement désignées par le terme RRAM, acronyme de l'anglais « resistive random accès memory » c'est-à-dire « mémoire résistive à accès aléatoire » où la mémorisation se fait en modifiant électriquement, de façon réversible, le matériau qui compose chaque cellule de façon à ce qu'il puisse prendre au moins deux valeurs distinctes de résistance pour y stocker un bit d'information. Parmi les différents types de mémoires résistives existantes celles dont le matériau de base est un diélectrique, normalement isolant, sont plus particulièrement considérées. Ces mémoires désignées par le terme OxRAM, qui fait référence à leur emploi d'un oxyde (Ox) comme matériau diélectrique, mettent en oeuvre un mode de fonctionnement dans lequel au moins un filament conducteur peut toutefois être formé entre deux électrodes séparées par l'oxyde après application d'une tension suffisamment importante entre celles-ci. Une fois que le filament a été formé, un état à faible résistance, généralement qualifié de LRS, de l'anglais « low resistance state », est obtenu. Cet état peut être inversé par une opération dite de « RESET », afin de remettre la mémoire dans un second état à forte résistance ou HRS de l'anglais « high resistance state », opération au cours de laquelle le ou les filaments sont rompus. Une fois que le filament a été formé une première fois une opération dite de « SET » peut remettre à nouveau la mémoire dans un état à faible résistance ou LRS en reformant au moins un filament. Cependant, contrairement à l'état à haute résistance, l'état à faible résistance où l'on forme au moins un filament conducteur est thermiquement instable. La durée de vie des filaments conducteurs, et donc le temps de rétention des informations stockées sous cette forme, diminue très rapidement avec l'augmentation de la température à laquelle ils sont soumis. Pour la température maximale de 260°C mentionnée précédemment, qui est atteinte durablement pendant une opération de soudage par refusion, le temps de rétention peut alors s'avérer être insuffisant pour garantir d'une façon fiable la rétention des informations qui y auraient été programmées préalablement. Les mémoires résistives de type RRAM ne peuvent donc être utilement préprogrammées avant assemblage puisque les informations stockées seront alors perdues lors de la phase de soudage par refusion.

Le document US2012081946 décrit une solution dans laquelle un état hautement résistif obtenu par programmation de la cellule est utilisé.

Il serait donc particulièrement avantageux de disposer de cellules mémoires permettant une grande densité d'intégration, au moins identique sinon meilleure que les mémoires Flash mentionnées ci-dessus, tout en autorisant une écriture plus rapide que ces dernières et qui seraient aussi capables de retenir leur information à des températures relativement élevées. La présente invention vise à répondre à cet objectif.

Un autre objectif de l'invention est de proposer une solution pour permettre à une cellule mémoire de ne pas perdre, lors d'une opération d'assemblage, une programmation effectuée au préalable.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Procédé de préprogrammation d'une matrice de cellules mémoire résistives non volatiles, lesdites cellules mémoire comprenant un matériau diélectrique disposé entre deux électrodes conductrices, lesdites cellules mémoire étant initialement dans un état résistif originel (HRS originel) et le matériau diélectrique étant apte à être modifié électriquement de manière à amener la cellule mémoire depuis l'état résistif originel (HRS originel) jusqu'à au moins un autre état résistif (LRS, HRS programmé), également désigné état résistif de préprogrammation, dans lequel la résistance de la cellule mémoire est au moins deux fois et de préférence au moins dix fois inférieure à la résistance de la cellule mémoire dans l'état résistif originel (HRS originel), au moins pour un intervalle de tensions de lecture.

Le procédé comprenant les étapes suivantes:
avant assemblage d'un composant contenant ladite matrice avec un support : programmer la matrice en amenant électriquement une pluralité de cellules depuis l'état résistif originel (HRS originel) jusqu'audit autre état résistif (LRS, HRS programmé) ; laisser les autres cellules mémoires dans leur état résistif originel (HRS originel).

Il s'avère que l'état résistif originel (HRS originel) reste stable même lorsque la cellule reçoit une quantité de chaleur importante du fait de l'étape d'assemblage qui comprend par exemple une étape de soudage ou de brasage. Après assemblage, les cellules laissées après programmation dans l'état résistif originel demeurent dans cet état. Les cellules amenées électriquement depuis l'état résistif originel (HRS originel) jusqu'à l'autre état résistif (LRS, HRS programmé) peuvent en revanche être altérées par l'apport de chaleur de l'étape d'assemblage et voir leur état résistif être modifié. Néanmoins, ces cellules, mêmes fortement altérées, ne retrouvent en aucun cas leur état résistif originel.

L'invention permet ainsi de différencier, après assemblage :
les cellules qui n'ont pas été programmées avant assemblage. Ces cellules demeurent dans l'état résistif originel après assemblage, par rapport aux cellules qui ont été programmées avant assemblage. Ces dernières cellules ont peut-être été altérées par l'assemblage, mais quoiqu'il en soit, elles ne sont pas dans l'état résistif originel. Ces cellules sont donc toutes les cellules qui ne sont pas dans l'état résistif originel.

L'invention offre ainsi une solution simple et robuste pour conserver la programmation d'une matrice de cellules mémoire résistives non volatiles après une étape de montage au cours duquel un stress thermique important est appliqué à la matrice.

En outre de manière particulièrement avantageuse, le procédé comprend l'étape suivante, après l'assemblage du composant contenant ladite matrice avec le support: appliquer, de préférence sur toutes les cellules de la matrice une tension intermédiaire également désignée tension de correction, ladite tension intermédiaire étant :
- inférieure à une première plage de tensions de valeurs suffisamment élevées pour pouvoir amener une cellule mémoire depuis l'état résistif originel (HRS originel) jusqu'à un deuxième état résistif (LRS) dans lequel la résistance de la cellule mémoire est au moins deux fois et de préférence au moins dix fois inférieure à la résistance de la cellule mémoire dans l'état résistif originel (HRS originel),
- supérieure à une deuxième plage de tensions de valeurs inférieures à la première plage mais suffisamment élevées pour pouvoir amener une cellule mémoire qui n'est pas dans l'état résistif originel (HRS originel) jusqu'audit deuxième état résistif (LRS).
les première et deuxième plages de tensions étant disjointes.

Ainsi, après l'application sur toutes les cellules de la matrice de la tension intermédiaire, les cellules qui avaient été laissées dans leur état résistif originel (HRS originel) ne seront en rien affectées car la tension intermédiaire est insuffisante pour changer cet état. Au contraire, l'application de la tension intermédiaire sur les cellules qui avaient été programmées en étant amenées dans un autre état (LRS, HRS programmé), moins résistif que l'état résistif originel (HRS originel) et qui avaient été altérées par l'application d'une température élevée lors de l'assemblage, seront amenées ou ramenées dans le deuxième état résistif (LRS). Par exemple, il peut s'agir de cellules dans lesquelles ont avait déjà formé un filament conducteur lors de la préprogrammation et dans lesquelles ce filament été partiellement défaits sous l'effet de l'apport de chaleur généré par l'étape d'assemblage. L'application de la tension intermédiaire va permettre de reformer les filaments involontairement défaits. Par ailleurs, les cellules qui avaient été rendues conductrices (ou moins résistives) lors de l'étape de programmation et qui avaient conservé le deuxième état résistif i.e., l'état conducteur ou moins résistif (LRS) malgré l'apport de chaleur resteront dans ce conducteur ou moins résistif (LRS) malgré l'apport de chaleur resteront dans ce deuxième état résistif (LRS). L'application de la tension intermédiaire n'amènera pas ces cellules dans un état non conducteur.

L'invention offre ainsi une solution simple et robuste pour conserver la programmation d'une matrice de cellules mémoire résistives non volatiles après une étape de montage au cours duquel un stress thermique important est appliqué à la matrice.

L'invention permet ainsi d'atteindre de grandes densités d'intégration des matrices de cellule mémoire et de prolonger leur durée de vie et leur robustesse face à un stress thermique.

Par ailleurs, l'invention permet de corriger l'information des cellules affectées par l'apport de chaleur sans pour autant nécessiter de connaître l'état avant assemblage et après programmation de chacune des cellules. Ainsi, l'invention permet de se passer d'une étape de lecture de chacune des cellules. Ainsi, en appliquant sur l'ensemble des cellules la tension de correction, et ceci quel que soit l'état avant assemblage de la cellule, l'invention permet de réduire considérablement le temps de traitement.

De manière générale, l'état résistif originel (HRS originel) i.e., l'état non conducteur originel est l'état obtenu à l'issue du procédé de fabrication des cellules mémoire et qui n'a été altéré par aucun passage de courant de programmation.

De manière facultative, le procédé selon l'invention comprend au moins l'une quelconque des étapes et caractéristiques suivantes.

Selon un mode de réalisation, le courant passant entre les deux électrodes conductrices traverse le matériau diélectrique. De préférence, tout le courant passant d'une électrode conductrice à l'autre traverse nécessairement le matériau diélectrique.

Selon un mode de réalisation, le matériau diélectrique est au contact de chacune des deux électrodes conductrices. De préférence, seul le matériau diélectrique est au contact de chacune des deux électrodes conductrices. Ainsi, il n'y a pas un autre matériau entre les deux électrodes conductrices sur le passage du courant. De préférence, il n'y a pas un autre matériau entre les deux électrodes conductrices. En particulier, il n'y a pas de matériau à changement de phase entre les deux électrodes conductrices. De manière plus générale, la cellule résistive ne comprend pas de matériau à changement de phase.

Avantageusement, les premières et deuxième plages de tensions sont disjointes et séparées par un intervalle intermédiaire de valeurs. Préférentiellement, la matrice de cellules mémoire est choisie de manière à ce que ledit intervalle intermédiaire de valeurs soit supérieur ou égal à 100 millivolts et de préférence au moins 200 millivolts. Préférentiellement, la matrice de cellules mémoire est choisie de manière à ce que ledit intervalle intermédiaire de valeurs soit supérieur ou égal à 500 millivolts.

Avantageusement, la tension intermédiaire est choisie pour être la plus élevée possible dans ledit intervalle intermédiaire de valeurs.

Avantageusement, au cours de l'étape d'assemblage les cellules mémoire sont soumises à une température d'au moins 240°C. Avantageusement, l'étape d'assemblage comprend l'application à la matrice d'une température supérieure ou égale à 240 degrés Celsius pendant au moins 10 secondes et de préférence d'au moins 260 degrés Celsius pendant au moins 10 secondes.

De préférence, l'étape d'assemblage du composant contenant ladite matrice avec le support comprend l'assemblage du composant sur une carte imprimée, une carte électronique, un autre composant électronique ou un boîtier.

Avantageusement, l'étape d'assemblage comprend une étape de brasage ou de soudage du composant sur le support ou un procédé de type WLCSP (acronyme de Wafer Level Chip Scale Packages dont une traduction en français peut être procédé de réalisation d'un boitier à la taille d'une puce au niveau du substrat).

De préférence, l'étape d'assemblage comprend une étape de brasage ou de soudage du composant sur le support au cours de laquelle les cellules mémoire sont soumises à une température d'au moins 240 °C pendant au moins 10 secondes. De préférence, l'étape d'assemblage comprend l'application d'une température supérieure ou égale à 260 degrés Celsius pendant au moins 10 secondes.

De préférence, l'étape d'assemblage, typiquement par WLCSP, comprend une étape au cours de laquelle les cellules mémoire sont soumises à une température supérieure à 300°C pendant plusieurs minutes. De préférence, l'étape d'assemblage comprend l'application d'une température supérieure ou égale à 300 degrés Celsius pendant au moins 30 minutes. De préférence, l'étape d'assemblage comprend l'application d'une température comprise entre 320°C et 375°C pour une durée comprise entre 40 et 80 minutes.

De préférence, ledit deuxième état résistif (LRS) est directement obtenu par application d'une tension depuis l'état résistif originel (HRS originel). Selon un mode de réalisation, ledit autre état résistif (LRS, HRS programmé) est ledit deuxième état résistif (LRS). Cet état est également qualifié d'état conducteur ou d'état faiblement résistif.

Selon un autre mode de réalisation, ledit autre état résistif (LRS, HRS programmé) est un troisième état résistif (HRS programmé) dans lequel la résistance de la cellule mémoire est au moins deux fois et de préférence au moins dix fois inférieure à la résistance de la cellule mémoire dans l'état résistif originel (HRS originel). La résistance de la cellule mémoire dans ce troisième état résistif présente une résistance différente de, typiquement supérieure, à celle de la cellule mémoire dans le deuxième état résistif (LRS). De préférence, programmer la matrice en amenant électriquement une cellule mémoire depuis l'état résistif originel (HRS originel) jusqu'au troisième état résistif (HRS programmé) comprend les étapes suivantes effectuées avant assemblage :
- appliquer une tension à la cellule mémoire de manière à amener la cellule mémoire depuis l'état résistif originel (HRS originel) jusqu'audit deuxième état résistif (LRS) ;
- appliquer une tension à la cellule de manière à amener la cellule mémoire depuis le deuxième état résistif (LRS) jusqu'au troisième état résistif (HRS programmé).

De préférence, amener la cellule mémoire dans ledit troisième état résistif (HRS programmé) est une opération de RESET.

Avantageusement, dans le troisième état résistif (HRS programmé) la cellule mémoire présente une résistance suffisamment supérieure à celle de la cellule mémoire dans le deuxième état résistif (LRS) de manière à ce qu'un circuit de lecture puisse identifier si la cellule est dans le deuxième état résistif (LRS) ou dans le troisième état résistif (HRS programmé).

Le troisième état résistif (HRS programmé) la cellule mémoire présente une résistance supérieure d'au moins un facteur 2, à la résistance de la cellule mémoire dans le deuxième état résistif (LRS) et de préférence d'au moins un facteur 10.

Le procédé comprend l'étape suivante d'identification effectuée après assemblage du composant contenant ladite matrice sur le support:
- pour au moins un ensemble de cellules mémoire de la matrice, appliquer une tension prise dans une plage de tensions de lecture inférieure en amplitude aux première et aux deuxième plages;
- si la cellule présente la résistance de l'état résistif originel (HRS originel), en déduire que la cellule était dans l'état résistif originel (HRS originel) après programmation et avant assemblage ; sinon, en déduire que la cellule n'était pas dans l'état résistif originel (HRS originel) après programmation et avant assemblage.
On pourra donc choisir d'avoir, après la préprogrammation et avant l'assemblage, l'un des couples suivants dans une même matrice de cellules:
- état résistif originel (HRS originel) / deuxième état résistif (LRS). Ce couple a pour avantage de présenter une différence de résistance très forte entre les deux états, ce qui permet une lecture très fiable même avec un dispositif de lecture relativement peu précis.
- état résistif originel (HRS originel) / troisième état résistif (HRS programmé). Ce couple a pour avantage de présenter une différence de résistance très forte entre les deux états.

Selon un mode de réalisation particulier, après l'étape de programmation et avant l'assemblage, lesdites cellules sélectionnées, i.e., les cellules de ladite pluralité de cellules amenées jusqu'audit autre état résistif, sont dans le deuxième état résistif (LRS) ou sont dans un troisième état résistif (HRS programmé) différent du deuxième état résistif (LRS) dans lequel la résistance de la cellule mémoire est au moins deux fois et de préférence au moins dix fois inférieure à la résistance de la cellule mémoire dans l'état résistif originel (HRS originel). Avantageusement, on effectue au moins un cycle d'étapes sur lesdites cellules sélectionnées amenées à l'autre état résistif (LRS, HRS programmé), chaque cycle consistant à amener électriquement lesdites cellules sélectionnées de la matrice depuis un état souhaité parmi le deuxième état résistif (LRS) et le troisième état résistif (HRS programmé) vers l'autre parmi ces deux états puis à ramener lesdites cellules à l'état souhaité.

Avantageusement, ces cycles d'étapes de RESET et de SET permettent de contrôler les états résistifs en fin de cycle de sorte à vérifier le bon fonctionnement des cellules sélectionnées. Par ailleurs, il s'avère que ces séquences d'opérations de RESET et de SET permettent également de stabiliser le filament conducteur qui est formé.

Préférentiellement, on effectue plusieurs cycles d'étapes. Cela permet de contrôler avec une meilleure probabilité le bon fonctionnement des cellules et de renforcer la stabilisation du filament conducteur formé.

Avantageusement, au terme d'au moins un cycle d'étapes on vérifie que les cellules sélectionnées sont dans l'état souhaité, et on identifie parmi les cellules sélectionnées, celles qui ne sont pas dans l'état souhaité.

Avantageusement, on transfert le contenu des cellules identifiées à d'autres cellules mémoire. L'information à stocker l'est donc uniquement dans des cellules dont le bon fonctionnement a été vérifié.

Ainsi, l'invention permet de conserver, après assemblage, une différence de résistance identifiable, entre d'une part les cellules mémoire qui avaient été modifiées électriquement avant assemblage et d'autre part celles qui n'avaient pas été modifiées électriquement avant assemblage.

Selon les modes de réalisation, on choisira de modifier ou non, après assemblage l'état résistif des cellules mémoire qui avaient été modifiées électriquement avant assemblage. Ainsi, ces cellules mémoire qui se trouvaient dans le deuxième état résistif (LRS) avant assemblage pourront, par application d'une tension après assemblage être amenées dans le troisième état résistif (HRS programmé).

Comme indiqué précédemment, on pourra également choisir ou non de modifier après assemblage l'état résistif des cellules mémoire qui n'avaient pas été modifiées électriquement avant assemblage. Ainsi, ces cellules mémoire qui se trouvaient dans l'état résistif originel (HRS originel) avant assemblage pourront :
- soit être toutes conservées dans l'état résistif originel (HRS originel),
- soit être toutes amenées dans le troisième état résistif (HRS programmé),
- soit être toutes amenées dans le deuxième état résistif (LRS).
On veillera naturellement à ce qu'après assemblage les cellules laissées dans l'état résistif originel lors de l'assemblage ne présentent pas, après assemblage et après une éventuelle reprogrammation, un état résistif identique à celui des autres cellules. On pourra donc choisir d'avoir, lors du fonctionnement de la cellule c'est-à-dire après assemblage, l'un des couples suivants dans une même matrice de cellules:
- état résistif originel (HRS originel) / deuxième état résistif (LRS). Ce couple a pour avantage de présenter une différence de résistance très forte entre les deux états, ce qui permet une lecture très fiable même avec un dispositif de lecture relativement peu précis.
- état résistif originel (HRS originel) / troisième état résistif (HRS programmé). Ce couple a pour avantage de présenter une différence de résistance très forte entre les deux états
- troisième état résistif (HRS programmé) / deuxième état résistif (LRS).

De préférence, les résistances des cellules mémoire de la matrice dans l'état résistif originel (HRS originel) sont comprises dans un premier intervalle de valeurs, les résistances des cellules mémoire dans le deuxième état résistif (LRS) sont comprises dans un deuxième intervalle de valeurs, les premier et deuxième intervalles étant disjoints au moins pour des tensions comprises dans l'intervalle de lecture. De préférence, les premier et deuxième intervalles présentent un écart d'au moins un ordre de grandeur et de préférence d'au moins deux ordres de grandeur, au moins pour des tensions comprises dans ledit intervalle de lecture. De préférence, les résistances des cellules mémoire dans le troisième état résistif (HRS programmé) sont comprises dans un troisième intervalle de valeurs, les premier et troisième intervalles étant disjoints au moins pour des tensions comprises dans ledit intervalle de lecture. De préférence, les premier et troisième intervalles présentent un écart d'au moins un ordre de grandeur et de préférence d'au moins deux ordres de grandeur, au moins pour des tensions comprises dans ledit intervalle de lecture. De préférence, les deuxième et troisième intervalles présentent un écart d'au moins un facteur 2 et de préférence d'au moins un facteur 10, au moins pour des tensions supérieures audit intervalle de lecture.

Avantageusement, identifier si chaque cellule mémoire est dans l'état résistif originel (HRS originel) comprend : l'application sur chaque cellule mémoire d'une tension comprise dans ledit intervalle de lecture et la mesure de l'intensité du courant traversant la cellule mémoire pour en déduire si la résistance de cette cellule mémoire est comprise dans la première plage de valeurs.

Selon un mode de réalisation avantageux, on prévoit pour la matrice un nombre de cellules mémoire supérieur à celui nécessaire à l'information à stocker, définissant ainsi des cellules mémoire test non destinées à contenir de l'information à stocker et on effectue, préalablement à la programmation, des tests sur lesdites cellules mémoire test de manière à déterminer les première et deuxième plages de tensions. On applique ainsi sur les cellules mémoire non utilisées des tensions pour identifier les seuils nécessaires à la formation du filament conducteur depuis l'état résistif originel (HRS originel) et pour reformer le filament depuis l'état non conducteur non originel (étape de SET) i e., le troisième état résistif (HRS programmé). On se sert ainsi de la matrice réelle pour déterminer la tension intermédiaire. Ce mode de réalisation offre une grande précision dans la détermination de l'intervalle situé entre les première et deuxième plages et de la tension intermédiaire.

Avantageusement, le passage d'un état résistif à l'autre s'effectue par application d'une tension aux bornes d'électrodes conductrices.

Par exemple, on qualifie d'état conducteur ou état à faible résistance (LRS) un état dans lequel la résistance de la cellule est inférieure ou égale à 1,5 kilo ohms et de préférence inférieure à 1000 ohms. Ces valeurs de résistance peuvent varier en fonction des applications. Plus généralement, on qualifie d'état conducteur ou à faible résistance l'état dans lequel est la cellule mémoire lorsque les filaments conducteurs sont formés. De manière plus générale, on qualifie d'état conducteur un état dans lequel la cellule mémoire présente une résistance inférieure à la résistance qu'elle présente dans l'état non conducteur ou résistif.

On qualifie d'état résistif originel (HRS) ou d'état non conducteur originel l'état obtenu avant toute application de tension visant à modifier la résistivité de la cellule mémoire. Typiquement, cet état originel est obtenu suite à la formation de la couche diélectrique et des électrodes.

Avantageusement, cet état originel est obtenu à l'issue des phases ultimes du procédé de fabrication et qui consistent essentiellement à l'interconnexion des composants élémentaires entre eux, typiquement les cellules mémoire, à la carte, et vers l'extérieur, à l'aide de plages et de connexions métalliques définies par photolithographie. Ces phases ultimes sont généralement qualifiées de BEOL, acronyme de l'anglais « back-end of line » c'est-à-dire étapes de « fin de ligne » de fabrication.

Généralement, au cours de ces étapes de BEOL les cellules mémoires doivent supporter des températures allant jusqu'à 400°C, typiquement, pendant quelques minutes et jusqu'à une dizaine de minutes.

De manière avantageuse, l'étape de programmation de la matrice pour amener électriquement un ensemble de cellules sélectionnées depuis l'état résistif originel (HRS originel) à l'état conducteur ou moins résistif (LRS) est effectuée après BEOL.

De manière également avantageuse, au cours de l'étape d'assemblage, on applique aux cellules mémoire un stress thermique inférieur à celui appliqué lors des étapes de BEOL, typiquement, on applique des températures inférieures à celles appliquées lors du BEOL.

Selon un mode de réalisation non limitatif, la cellule mémoire comprend uniquement deux électrodes et une couche diélectrique disposée entre les deux électrodes. Eventuellement, une couche d'interface se forme naturellement entre la couche diélectrique et l'une au moins des électrodes. Avantageusement, cette structure est simple à réaliser et peut être obtenue de manière particulièrement fiable. De préférence, les cellules mémoire de comprennent pas de matériau à changement de phase.

Le diélectrique est avantageusement un oxyde. La cellule mémoire est avantageusement de type OxRAM.

La tension intermédiaire est supérieure audit intervalle de lecture en valeur absolue pour un fonctionnement bipolaire et unipolaire. En fonctionnement bipolaire, pour faire un RESET électrique, il faut appliquer une tension négative (ou opposée par rapport à la tension de forming).

En fonctionnement unipolaire, pour faire un RESET électrique il suffit de rester dans la même polarisation et d'augmenter de tension par rapport aux tensions utilisées en lecture.

L'invention a également pour objet un procédé de fabrication d'un dispositif microélectronique comprenant les étapes de la méthode de préprogrammation.

En outre, le procédé comprend de préférence au moins une étape d'assemblage du composant sur un support tel qu'une carte électronique, un autre composant ou un boîtier.

L'invention s'applique aussi bien aux cellules mémoire présentant un fonctionnement polarisé qu'aux cellules mémoires présentant un fonctionnement non polarisé.

Selon un autre mode de réalisation, l'invention a également pour objet une matrice de cellules mémoire résistives non volatiles (RRAM) programmées en mettant en oeuvre le procédé selon l'un quelconque des modes de réalisation de l'invention.

Selon un autre mode de réalisation, l'invention a également pour objet une matrice de cellules mémoire résistives non volatiles (RRAM) selon l'invention, les mémoires étant pour certaines au moins de type mémoire à accès aléatoire comportant un oxyde (OxRAM).

Selon un autre mode de réalisation, l'invention a également pour objet un dispositif microélectronique comprenant au moins une matrice de cellules mémoire résistives non volatiles programmées en mettant en oeuvre le procédé selon un mode de réalisation de l'invention.

Selon un autre mode de réalisation, l'invention a également pour objet un dispositif microélectronique comprenant une matrice de cellules mémoire résistives non volatiles comprenant un matériau diélectrique disposé entre deux électrodes conductrices, la cellule étant configurée de manière à ce que le matériau diélectrique soit traversé par un courant électrique lorsque les électrodes conductrices sont connectées à une source électrique, le matériau diélectrique étant apte à être modifié électriquement de manière à amener la cellule mémoire depuis un état résistif originel (HRS originel) correspondant à un premier état résistif jusqu'à au moins un autre état résistif (LRS, HRS programmé) dans lequel la résistance de la cellule mémoire est au moins deux fois inférieure à la résistance de la cellule mémoire dans l'état résistif originel (HRS originel), dans lequel la matrice est contenue dans un composant, dans lequel le composant est assemblé avec un support, caractérisé en ce que certaines des cellules de la matrice sont dans l'état résistif originel (HRS originel) et que les autres cellules sont dans un état résistif différent de l'état résistif originel (HRS originel).

Par dispositif microélectronique, on entend tout type de dispositif réalisé avec des moyens de la microélectronique. Ces dispositifs englobent notamment en plus des dispositifs à finalité purement électronique telle que des mémoires, des dispositifs micromécaniques ou électromécaniques (MEMS, NEMS...) ainsi que des dispositifs optiques ou optoélectroniques (MOEMS...)

Selon un autre mode de réalisation, l'invention prévoit un procédé de préprogrammation d'une matrice de cellules mémoire résistives non volatiles, lesdites cellules mémoire comprenant un matériau diélectrique disposé entre deux électrodes conductrices et étant aptes à amener électriquement et de manière réversible le matériau diélectrique depuis un état non conducteur à un état conducteur ou moins résistif (LRS) que l'état non conducteur, le procédé comprenant les étapes suivantes: avant assemblage d'un composant contenant ladite matrice avec un support,
programmer la matrice en amenant électriquement un ensemble de cellules sélectionnées depuis un état non conducteur originel à un état conducteur ou moins résistif (LRS) que l'état non conducteur. On laisse ainsi des cellules mémoires non sélectionnées dans leur état non conducteur originel.
Le procédé comprend en outre l'étape suivante, après l'assemblage sur le support du composant contenant ladite matrice :
appliquer sur toutes les cellules de la matrice une tension intermédiaire, ladite tension intermédiaire étant inférieure à une première plage de tensions de valeurs suffisamment élevées pour pouvoir amener le matériau diélectrique depuis l'état non conducteur originel à l'état conducteur ou moins résistif (LRS) et ladite tension intermédiaire étant supérieure à une deuxième plage de tensions de valeurs inférieures à la première plage mais suffisamment élevées pour pouvoir amener le matériau diélectrique dans l'état conducteur ou moins résistif (LRS) depuis un état non conducteur différent de l'état non conducteur originel et obtenu suite à une amenée préalable du matériau diélectrique à l'état conducteur ou moins résistif (LRS).
Selon un autre mode de réalisation, l'invention porte sur un procédé de préprogrammation d'une matrice de cellules mémoire résistives non volatiles, lesdites cellules mémoire comprennent un matériau diélectrique disposé entre deux électrodes conductrices, le procédé comprenant les étapes suivantes :
avant montage sur un support d'un composant contenant ladite matrice,
   à former électriquement dans un ensemble de cellules sélectionnées de la matrice mémoire, des filaments conducteurs dans le matériau diélectrique entre les deux électrodes ;
   à laisser des cellules mémoires non sélectionnées dans leur état non conducteur originel ;
le procédé comprenant en outre, après montage sur le support du composant contenant ladite matrice,
   une étape de reprogrammation électrique de toutes les cellules mémoires de la matrice de cellules de façon à reformer les filaments conducteurs dans les cellules préprogrammées qui auraient pu être défaits par l'opération d'assemblage du composant sur le circuit imprimé.

Avantageusement, l'étape de reprogrammation comprend l'application sur l'ensemble des cellules de la matrice mémoire d'une tension intermédiaire entre, d'une part, une première plage de tensions de valeurs assez élevées pour former les filaments conducteurs dans le matériau depuis son état originel, et d'autre part, une deuxième plage de tensions de valeurs inférieures à la première plage mais cependant suffisantes pour pouvoir reformer les filaments conducteurs déjà formés au moins une première fois.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a à 1c décrivent brièvement un exemple de mémoire RRAM de type OxRAM et son mode de fonctionnement.
Les FIGURE 2a à 2d illustrent d'autres exemples de mémoires RRAM utilisant un matériau diélectrique et des structures d'électrodes différents.
Les FIGURES 3a à 3c illustrent le critère qui permet de mettre en oeuvre dans les mémoires de type OxRAM le procédé de préprogrammation de l'invention.
Les FIGURE 4a à 4c illustrent le procédé de préprogrammation de l'invention.

Les dessins joints sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Il est précisé que dans le cadre de la présente invention, le terme « sur », « surmonte » ou « sous jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

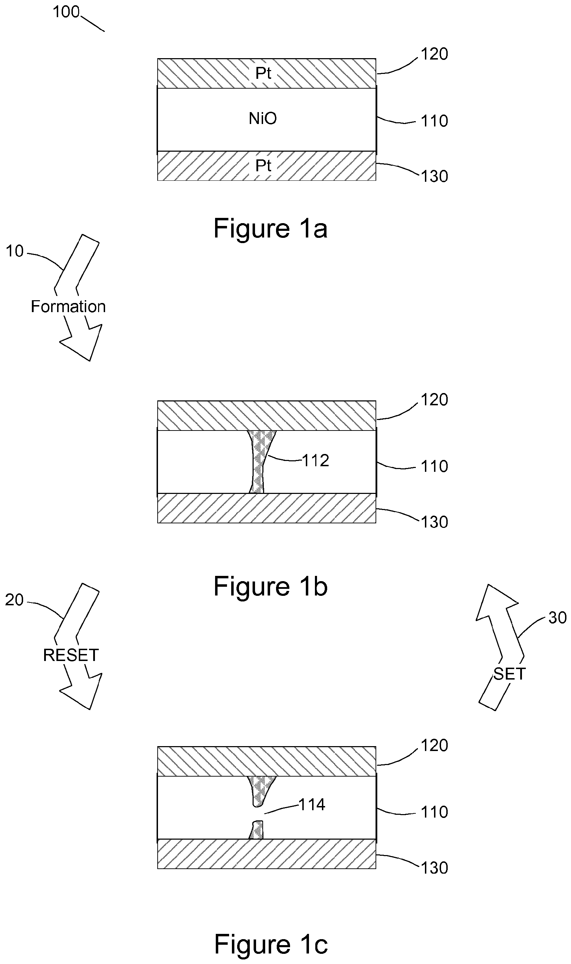

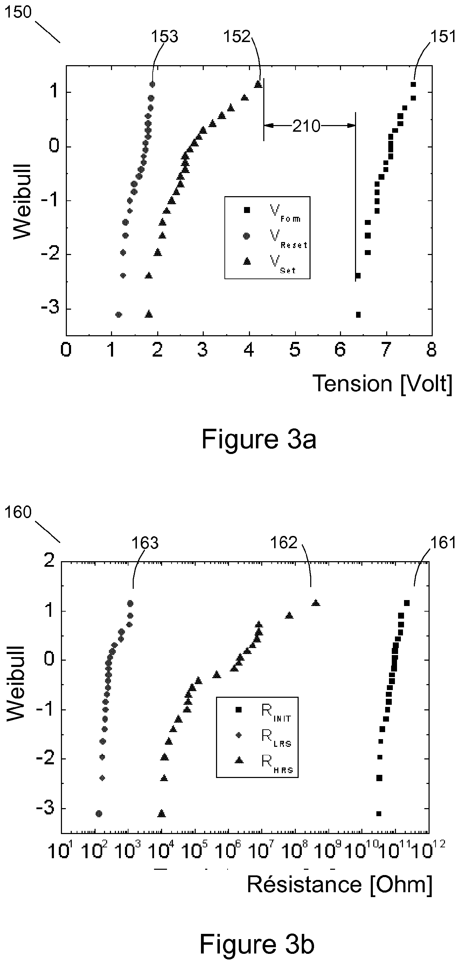

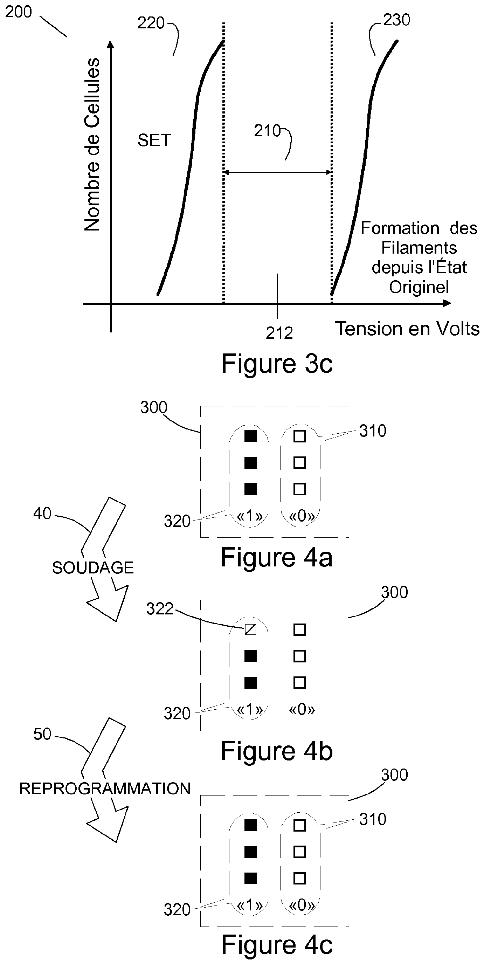

Les **figures 1a, 1b** et **1c** décrivent brièvement un exemple de mémoire résistive (RRAM) de type OxRAM et son mode de fonctionnement. On notera ici que le mode de fonctionnement d'autres mémoires RRAM est similaire. Il s'agit par exemple des mémoires dites CBRAM, acronyme de l'anglais « conductive bridge random-access memory » où, comme le nom le suggère, des « ponts conducteurs » similaires aux filaments décrits sont formés dans un matériau non conducteur. Ces mémoires, et d'autres basées sur les mêmes principes, sont également susceptibles de pouvoir bénéficier de l'invention et l'invention n'est limitative d'aucun des types de mémoires résistives. On notera ici que l'invention est susceptible de s'appliquer quel que soit le mécanisme mis en oeuvre par la mémoire non volatile considérée pour peu que la gamme de tensions pour la formation initiale d'un chemin conducteur, quelle que forme qu'il prenne, depuis l'état originel après fabrication, soit nettement différentiée de la gamme de tensions nécessaire à sa reformation (SET) lors de l'utilisation fonctionnelle du dispositif, comme illustré plus loin dans la figure 3.

La figure 1a illustre la structure d'une cellule mémoire OxRAM 100 où le matériau diélectrique 110 est dans cet exemple de l'oxyde de nickel (NiO) compris entre deux électrodes métalliques, 120 et 130, en platine (Pt).

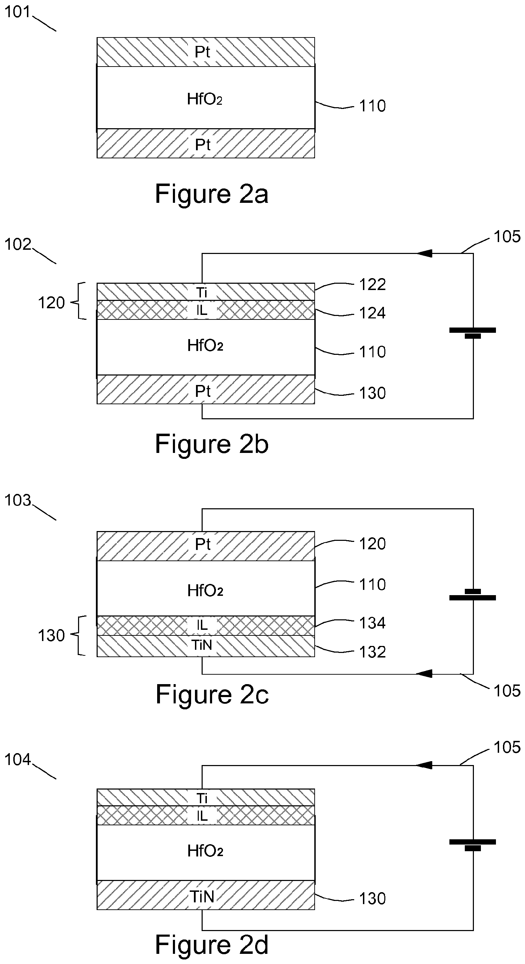

La figure 1b illustre la formation initiale d'un filament conducteur 112 résultant de l'application entre les deux électrodes métalliques d'une tension adéquate dépendant entre autre, comme on va le voir dans la figure 2, de la nature des matériaux employés.

On notera ici que les phénomènes physicochimiques conduisant à la formation d'un filament conducteur 112 sous l'effet de l'application d'une tension électrique suffisante sur les électrodes, et la nature même du filament, restent largement incompris de la communauté scientifique travaillant dans ce domaine. Différents mécanismes ont été avancés pour expliquer la formation des filaments qui incluent la présence de défauts et la migration du métal constituant les électrodes. Toutefois, comme montré sur la figure 1b, on observe bien au cours d'une première étape 10 la formation initiale d'au moins un filament conducteur 112, ou d'un chemin conducteur quel qu'il soit, en appliquant une différence de potentiel suffisante entre les deux électrodes, 120 et 130.

Les cellules mémoire selon l'invention présentent plusieurs états correspondant chacun à un niveau de résistance électrique de la cellule. On peut ainsi dénombrer trois états :
- un état résistif originel, également désigné état non conducteur originel ou état fortement hautement originel. Dans la présente demande de brevet, cet état est également qualifié d'état HRS originel (acronyme de highly resistive state originel en anglais). Cet état est également qualifié de premier état résistif.

On qualifie d'état non conducteur originel l'état obtenu avant toute application de tension visant à modifier la résistivité de la cellule mémoire. Cet état originel est obtenu suite à la formation de la couche diélectrique et des électrodes. Avantageusement, cet état originel est obtenu à l'issue des phases ultimes du procédé de fabrication et qui consistent essentiellement à l'interconnexion des composants élémentaires entre eux, typiquement les cellules mémoire, à la carte, et vers l'extérieur, à l'aide de plages et de connexions métalliques généralement définies par photolithographie. Ces phases ultimes sont généralement qualifiées de BEOL, acronyme de l'anglais « back-end of line » c'est-à-dire étapes de « fin de ligne » de fabrication. Généralement, au cours de ces étapes de BEOL les cellules mémoires doivent supporter des températures allant jusqu'à 400°C, typiquement, pendant quelques minutes et jusqu'à une dizaine de minutes. De manière avantageuse, l'étape de programmation de la matrice pour amener électriquement un ensemble de cellules sélectionnées depuis l'état non conducteur originel à l'état conducteur ou moins résistif (LRS) est effectuée après BEOL. De manière également avantageuse, au cours de l'étape d'assemblage, on applique aux cellules mémoire un stress thermique inférieur à celui appliqué lors des étapes de BEOL, typiquement, on applique des températures inférieures à celles appliquées lors du BEOL.

Dans cet état, l'information codée en binaire par la cellule est par exemple un « 0 ».
- un état conducteur ou peu résistif, également désigné état à faible résistance. Cet état est également qualifié de deuxième état résistif. Par souci de concision et de clarté, dans la présente demande de brevet, cet état est également qualifié d'état LRS. LRS étant l'acronyme de low resitive state en anglais, signifiant état à faible résistance. Cet état LRS est obtenu en appliquant une tension à la cellule mémoire se trouvant dans l'état HRS originel. Cet état est donc obtenu directement à partir de l'état résistif originel (HRS originel).

Une explication de l'augmentation de la conductivité dans cet état LRS repose sur la formation des filaments. De manière plus générale, on qualifie d'état conducteur un état dans lequel la cellule mémoire présente une résistance inférieure à la résistance qu'elle présente dans un état non conducteur ou résistif. A titre d'exemple non limitatif, on peut qualifier d'état conducteur ou électriquement peu résistif un état dans lequel la résistance de la cellule est inférieure ou égale à 1,5 kilo ohms et de préférence inférieure à 1000 ohms. Ces valeurs de résistance peuvent largement varier en fonction des applications et/ou de la structure et de la composition de la cellule mémoire.

Dans cet état, l'information codée en binaire par la cellule dans l'état LRS sera par exemple un « 1 » si l'information codée par la cellule dans l'état HRS originel est un « 0 ». Inversement, l'information codée en binaire par la cellule dans l'état LRS sera un « 0 » si l'information codée par la cellule dans l'état HRS originel est un « 1 ».
- un état résistif programmé ou état fortement résistif programmé ou état à haute résistance programmé. Cet état est également qualifié de troisième état résistif. Par souci de concision, dans la présente demande de brevet, cet état est également qualifié d'état « HRS programmé ». Cet état HRS programmé est obtenu en appliquant une tension à la cellule mémoire se trouvant dans l'état LRS. La résistance de la cellule mémoire dans cet état résistif programmé est néanmoins toujours inférieure à la résistance de la cellule dans l'état hautement résistif originel (HRS originel).

On qualifie usuellement de RESET l'opération qui consiste à amener la cellule mémoire depuis l'état LRS à l'état HRS programmé. En fonction des applications, on peut considérer qu'une cellule mémoire dans l'état HRS programmé porte l'information « 0 » si la cellule dans l'état LRS porte l'information « 1 » ou inversement, que la cellule mémoire dans l'état HRS programmé porte l'information « 1 » si la cellule dans l'état LRS porte l'information « 0 ».

Les états HRS originel, LRS et HRS programmé présentent des résistances différentes. Plus précisément, la résistance des cellules dans l'état HRS originel doit être clairement différentiable de la résistance des cellules dans l'état HRS programmé ou dans l'état LRS et ceci pour toutes les cellules du dispositif.

En fonction du type de mémoire OxRAM considéré, dont la figure 1 n'est qu'un exemple, on observe deux modes de fonctionnement différents :
- L'un est dit unipolaire ou non polarisé. C'est-à-dire que les opérations de formation ou de reformation d'un filament conducteur ou SET, et de rupture du filament ou RESET, ne dépendent pas de la polarité de la tension appliquée.
- L'autre est dit bipolaire ou polarisé. Les opérations de SET et de RESET se font avec des polarités opposées.

Quel que soit le mode de fonctionnement, la figure 1c illustre la rupture 114 du filament qui est obtenue à l'issue d'une opération 20 de RESET qui place ou replace la cellule mémoire dans un état à haute résistance (HRS). La reformation 112 du filament est obtenue à l'issue d'une opération 30 de SET. La cellule mémoire est alors à nouveau dans un état à faible résistance (LRS) dont a vu qu'il était thermiquement instable.

Les **figures 2a** à **2d** illustrent d'autres exemples de mémoires RRAM utilisant un matériau diélectrique et des structures d'électrodes différents. L'invention n'est pas limitée à ces autres exemples et s'étend à de nombreuses autres structures de cellule mémoire vérifiant les conditions mentionnées ci-dessous pour effectuer les opérations de changement de résistivité.

La figure 2a montre une première structure 101 similaire à celle de la figure 1a dans laquelle le matériau diélectrique 110 est alors constitué d'oxyde d'hafnium (HfO2). On notera dans ce cas qu'il y a un consensus de la communauté scientifique pour conclure que l'état conducteur ou faiblement résistif d'une cellule mémoire faite d'oxyde d'hafnium est obtenu en raison de la formation de lacunes en oxygène et de leur agrégation.

Le HfO2, dont les résultats sont montrées dans les figures 3, est déposé par ALD, acronyme de l'anglais « atomic layer déposition » c'est-à-dire « dépôt en couches atomiques » dans un appareillage spécialisé avec les conditions suivantes:
- température de dépôt : 350°C ;
- pression : 1 Torr ;
- gaz précurseurs : tétrachlorure de hafnium (HfCl4) et eau (H2O) en phase vapeur, envoyés par cycles séparés sur la tranche. Un cycle complet se compose de: un pulse de HfCl4, une purge d'azote (N2), un pulse de H2O, 1 purge d'azote.
- Pour faire croître 10 nm de HfO2 il faut 180 cycles.

La liste des matériaux dans lesquels des filaments conducteurs sont susceptibles de se développer comprend potentiellement, outre les oxydes de nickel et d'hafnium mentionnés ci-dessus, les matériaux suivants : tous les oxydes qui fonctionnent selon le même modèle, c'est-à-dire à partir de la formation de lacunes en oxygène.

Ces figures 2a-2d laissent clairement apparaître que le matériau diélectrique 110 est disposé sur le chemin de passage du courant. Le courant passant d'une électrode 120, 130 à l'autre doit nécessairement traverser ce matériau diélectrique 110. Comme illustré sur ces figures, le matériau diélectrique 110 est au contact de chacune des deux électrodes 120, 130. Aucun autre matériau n'est prévu entre le matériau diélectrique 110 et les deux électrodes 120, 130 lors de la fabrication de la cellule.

La figure 2b illustre une deuxième structure 102 de cellule mémoire dans laquelle l'électrode supérieure 120 est différente de l'électrode inférieure 130. En particulier, l'électrode supérieure comprend une couche 122 faite de titane (Ti), voire une autre couche 124. Cette autre couche constitue une couche d'interface 124 avec l'oxyde d'hafnium 110. Il s'agit d'une couche sous stoechiométrique en oxygène de HfO2. Elle est désignée par l'acronyme « IL » de l'anglais « interfacial layer». La couche 124 se forme naturellement à cause du titane (Ti) de la couche 122 qui absorbe l'oxygène de la couche 110 faite de HfO2. La couche 124 n'est pas déposée intentionnellement. Seule la couche 122 constitue à proprement parler l'électrode supérieure dont une partie du titane va se fondre avec le HfO2 selon le phénomène décrit ci-dessus. Dans la structure de la figure 2b l'électrode inférieure 130 est comme précédemment en platine. Dans la figure 2b, et pour les structures asymétriques suivantes, les tensions positives sont appliquées comme indiqué par la référence 105.

La figure 2c illustre une troisième structure 103 de cellule mémoire dans laquelle c'est l'électrode supérieure 120 qui reste en platine. L'électrode inférieure 130 comprend dans ce cas deux couches. La couche 134 est identique à la couche d'interface (IL) décrite ci-dessus. La couche 132 est faite de nitrure de titane (TiN).

La figure 2d illustre une quatrième structure 104 de cellule mémoire qui est similaire à la structure 102 décrite dans la figure 2b. La différence étant que l'électrode inférieure 130 est alors constituée de nitrure de titane (TiN) en remplacement du platine.

Les résultats expérimentaux obtenus avec ces structures sont résumés dans le tableau ci-après :

| Référence de la structure (figures 2a à 2d) | Tension en volts pour former un filament depuis l'état originel | Tension en volts appliquée lors d'une opération de SET | Tension en volts appliquée lors d'une opération de RESET | Résistance en Ohms après une opération de SET | Résistance en Ohms après une opération de RESET |
|---|---|---|---|---|---|
| Mode de fonctionnement polarisé | | | | | |
| 101 | 4,7 ± 0,3 | 3 ± 1,5 | - 0,3 ± 0,1 | ∼ 600 | 1 x 10⁶ à 100 x 10⁶ |
| 102 | 1,35 ± 0,58 | 0,85 ± 0,2 | - 0,8± 0,1 | ∼ 800 | 10 x 10³ à 1 x 10⁶ |
| 103 | 4,4, ± 0,3 | 1,3 ± 0,8 | - 1,1 ± 0,4 | ∼ 1000 | 10 x 10³ à 1 x 10⁶ |
| 104 | 1,90 ± 0,14 | 0,45 ± 0,1 | - 0,43 ± 0,2 | 400 | 6 x 10³ à 20 x 10³ |

Il convient de noter que ces valeurs sont expérimentales et qu'elles peuvent varier d'un lot à un autre. De plus on remarquera que les structures expérimentales utilisées pour établir ces valeurs n'ont pas d'élément sélecteur série comme dans une cellule mémoire standard

Les **figures 3a et 3b** montrent d'autres résultats expérimentaux concernant le mode de fonctionnement non polarisé de la structure 101 illustrée par la figure 2a. Dans ce cas, la couche d'oxyde d'hafnium a une épaisseur de 20 nm.

La figure 3a montre dans le diagramme 150, pour un lot de dispositifs correspondant à la structure 101, les distributions de type Weibull : des tensions de formation 151 d'un filament ou chemin conducteur depuis l'état originel du matériau déposé ; des tensions de RESET 153 pour rompre ce filament et des tensions de SET 152 pour le rétablir. On notera ici que les distributions de SET 152 et de formation du filament 151 sont disjointes 210.

La figure 3b montre dans le diagramme 160, pour le même lot de dispositifs, les distributions des résistances des cellules dans les différents états : dans l'état originel du matériau 161, après une opération de rupture du filament (RESET) 162 où l'on est dans l'état dit HRS et après une opération de rétablissement du filament (SET) 163 où l'on se trouve dans l'état dit LRS.

L'invention est basée sur la remarque qu'il est possible, comme expliqué dans les figures suivantes, de préprogrammer utilement celles des mémoires correspondant aux structures des figures 2a à 2d pour lesquelles la plage des tensions de SET ne recouvre pas celle nécessaire à la formation d'un filament 112 depuis l'état originel du matériau 110. Dans le tableau précédent les structures 103 et 104 satisfont ce critère. C'est aussi le cas pour la structure 101 non polarisée de la figure 3a. La méthode de préprogrammation décrite ci-après va permettre en effet de restaurer après une forte élévation de température (imposée lors d'une étape de soudage ou de brasage par exemple) l'information préprogrammée pour peu que le critère ci-dessus soit satisfait.
La **figure 3c** précise ce critère dans le diagramme 200 en spécifiant que les populations de cellules présentes sur une tranche doivent être suffisamment disjointes, comme précédemment dans la figure 3a, pour qu'il soit possible de définir une tension intermédiaire 212, entre les deux distributions 220 et 230, qui assure que toutes les cellules pourront supporter une opération de SET sans que les cellules où le matériau est resté dans son état originel puisse atteindre un état conducteur ou peu résistif puisque la tension appliquée 212 sera alors insuffisante. L'application de la tension intermédiaire 212 ne permet pas en effet la formation d'un filament conducteur dans les cellules mémoires se trouvant dans l'état résistif originel (HRS originel). On rappelle ici que l'état résistif originel (HRS originel) également désigné état non conducteur originel est l'état obtenu avant toute application de tension visant à modifier la résistivité de la cellule mémoire.
Typiquement, cet état originel est obtenu suite à la formation de la couche diélectrique et des électrodes.

Le non-recouvrement des première 220 et deuxième 230 plages est illustré dans les figures 3a et 3c par l'intervalle 210.

Un minimum de 100 millivolts, de préférence au moins 200 millivolts et encore de préférence au moins 500 millivolts doivent séparer les première 220 et deuxième 230 plages de tensions. On notera ici que l'homme du métier saura établir un diagramme 200 du type de celui de la figure 3 en procédant à une caractérisation préalable de la technologie utilisée sur des tranches représentatives de celle-ci. Optionnellement, des essais pourront aussi être pratiqués sur des parties inutilisées de matrices mémoires qui doivent être préprogrammées pour estimer l'amplitude des deux distributions, 220 et 230, identifier la présence d'un intervalle intermédiaire 210 et déterminer le seuil d'écriture 212 optimal de l'ensemble des cellules après l'élévation de température (soudage par exemple) qui va permettre de retrouver l'information préprogrammée comme expliqué ci-après. Ainsi, si l'ensemble des informations à enregistrer dans la matrice nécessite un nombre de cellules mémoire inférieur au nombre de cellules mémoire de la matrice, alors une partie des cellules mémoire non utilisées pour enregistrer l'information est avantageusement utilisée pour identifier les deux distributions, 220 et 230. On applique ainsi sur ces cellules mémoire non utilisées des tensions pour identifier les seuils nécessaires à la formation du filament conducteur depuis l'état résistif originel (HRS originel) et pour reformer le filament depuis l'état non conducteur non originel (étape de SET).

Les **figures 4a, 4b** et **4c** illustrent le procédé de préprogrammation de l'invention qui peut s'appliquer quand les conditions décrites dans les figures précédentes sont satisfaites.

La figure 4a illustre l'étape de préprogrammation qui s'effectue sur chaque matrice mémoire 300 typiquement contenue dans une puce électronique et dans laquelle on désire stocker des informations. Dans le contexte de l'invention ce stockage se fait avantageusement, pour les raisons exposées dans le chapitre sur l'état de la technique, en fin de cycle de fabrication des puces, avant leur montage sur un circuit imprimé constituant tout ou partie d'un système embarqué, où elles devront alors subir les températures engendrées par le soudage par refusion des composants. La préprogrammation électrique en fin de cycle de programmation peut se faire avec les moyens conventionnels développés par l'industrie de la microélectronique. Notamment, la préprogrammation pourra se faire à l'aide d'un outillage électromécanique adéquat sur l'ensemble des puces contenues sur une tranche avant découpage de cette dernière ou sur chaque puce individuellement après découpage.

Quel que soit le stade de fabrication où la préprogrammation est effectuée et quels que soient les moyens employés l'invention prévoit que l'information préprogrammée l'est sous deux formes :
- un ensemble de cellules mémoire 310 est laissé dans l'état originel, celui résultant du cycle de fabrication. On n'applique sur ces cellules aucun signal électrique susceptible d'en modifier la structure physicochimique. Notamment, les tensions éventuellement appliquées restent toujours bien inférieures aux tensions qu'il faudrait appliquer pour la formation des filaments conducteurs. Les cellules de cet ensemble sont donc dans un état HRS à forte résistance.
- un autre ensemble de cellules mémoire 320, généralement l'ensemble complémentaire de la matrice mémoire 300 que l'on désire préprogrammer, est choisi sur lequel on va procéder individuellement, dans chacune des cellules mémoire sélectionnées, à la formation électrique des filaments conducteurs comme expliqué précédemment. Ces cellules mémoires seront alors mises dans un état à faible résistance (LRS). On notera qu'il est possible, voire fréquent, que toutes les cellules mémoires d'une matrice mémoire d'une puce que l'on désire préprogrammer pour une application particulière ne soient pas en pratique utilisées. En fonction de mises en oeuvre spécifiques de l'invention les cellules mémoires inutilisées par l'application pourront servir de cellules d'essai comme déjà mentionné dans la figure précédente. Elles pourront tout aussi bien être laissées dans l'état originel ou au contraire placées volontairement dans l'état LRS.

Ici il convient de remarquer que pour désigner l'état binaire que peut prendre une cellule mémoire, les chiffres « 0 » et « 1 » sont très communément employés. Dans le domaine de l'invention, on associe généralement le « 0 » à l'état HRS. C'est celui à forte résistance qui doit être détecté par un circuit de lecture (non représenté) de la matrice sous la forme d'une absence de courant ou d'un courant restant suffisamment faible pour qu'il ne soit pas détectable par celui-ci. Au contraire, dans l'état LRS le circuit de lecture peut détecter le passage d'un courant plus important et on associe donc généralement cet état au chiffre « 1 ». Cette convention, la plus employée, est aussi utilisée dans la description qui suit de cette invention. La convention contraire pourrait cependant tout aussi bien être utilisée. Ainsi, dans le langage courant partagé par tous ceux qui travaillent dans ce domaine, l'étape de préprogrammation consiste à programmer des « 1 », c'est-à-dire des valeurs faibles de résistance, dans un ensemble de cellules mémoire qui sont spécifiques à une application donnée. Les autres cellules étant laissées dans leur état originel à forte résistance, c'est-à-dire dans l'état « 0 ».

La figure 4b illustre l'effet sur les matrices mémoires 300 d'un apport de chaleur. Typiquement et comme indiqué précédemment, cet apport de chaleur est provoqué par une opération d'assemblage du composant comportant la matrice de cellules mémoire sur un support tel qu'une carte électronique, un boîtier encapsulant le composant ou sur un autre composant. Cette opération d'assemblage comprend par exemple une étape de soudage par refusion 40 habituellement désigné « solder reflow » en anglais.

Comme on l'a vu l'état « 1 » préprogrammé est thermiquement instable. Certaines des cellules 322 au moins, sinon toutes celles de l'ensemble 320, sont susceptibles d'être affectées par une température qui atteint comme on l'a vu 260°C, typiquement pendant une période de temps de l'ordre de 2 minutes. Par exemple, les filaments 112 qui ont été formés pour la préprogrammation seront alors partiellement défaits 114, comme après une opération de RESET.

La figure 4c illustre le résultat de l'étape de l'invention qui prévoit qu'après assemblage, et donc après l'étape d'apport d'une quantité importante de chaleur (soudage par exemple) des puces préprogrammées sur leurs circuits imprimés, toutes les matrices mémoires préprogrammées contenues dans ces puces sont à nouveau « reprogrammées » en utilisant cette fois le niveau électrique intermédiaire 212 tel que défini dans la figure 3.

On notera que cette étape de reprogrammation 50, qui s'effectue une seule fois après assemblage, ne nécessite en rien de connaître la préprogrammation spécifique qui aura été utilisée en fin de ligne de fabrication. En effet, cette étape caractéristique de l'invention prévoit que toutes les cellules mémoires d'une matrice mémoire préprogrammée sont systématiquement parcourues pour être reprogrammées avec le niveau électrique intermédiaire 212.

Dans ces conditions, les cellules 310 qui avaient été laissées dans leur état originel ne seront en rien affectées car la tension de reprogrammation 212 appliquée est comme on l'a vu insuffisante pour changer cet état. Au contraire, l'application de la tension de reprogrammation sur les cellules 320 dans lesquelles ont avait déjà formé un filament conducteur va reformer les filaments qui ont été partiellement défaits à l'issue du soudage, comme lors d'une opération de SET. On retrouve alors l'état LRS à faible résistance et la préprogrammation est complètement restaurée. Les circuits de lecture peuvent à nouveau distinguer les niveaux « 1 » préprogrammés des niveaux « 0 ».

Si on considère la structure 103 décrite dans la figure 2c on voit d'après les valeurs figurant dans la ligne correspondante du tableau précédent qu'un pulse de tension de reprogrammation d'une valeur intermédiaire 112, par exemple de 3 volt, peut convenir puisqu'elle est inférieure à la valeur la plus faible nécessaire pour former un filament, c'est-à-dire 4,4 - 0.3 = 4,1 volts et qu'elle est supérieure à la valeur la plus élevée requise pour une opération de SET, c'est-à-dire 1,3 + 0.8 = 2,1 volt. Dans cet exemple, on peut prévoir que la couche de HfO₂ ait une épaisseur d'environ 10nm et que cette couche soit déposée par déposition de couches atomiques (ALD).

Toutefois, on remarquera que dans la mesure où la distribution des tensions nécessaires pour amener la cellule dans le deuxième état résistif (LRS) i.e., l'état conducteur (par exemple par formation des filaments), c'est-à-dire la plage 230 de la figure 3c, est bien caractérisée pour une technologie et une structure de cellule mémoire données, il est préférable d'utiliser une tension intermédiaire 112 de reprogrammation après soudage qui soit la plus près possible de la borne inférieure de cette plage afin de garantir la fiabilité de l'étape 50 de reprogrammation c'est-à-dire toutes les opérations de SET qui replacent les cellules dans leur deuxième état résistif (LRS) après qu'elles aient été amenées dans leur état résistant après soudage (opérations de SET qui reforme les filaments qui ont été défaits après soudage).

Le procédé de préprogrammation décrit ci-dessus s'applique sans restriction aux mémoires OXRAM dont le mode de fonctionnement est dit être polarisé ou bipolaire.

Dans le cas des mémoires où le fonctionnement est non polarisé, comme celui de la structure 101, le procédé de l'invention devient le suivant :
Les cellules qui avaient été laissées dans leur état originel « 0 » ne seront en rien affectées car la tension de reprogrammation appliquée est comme on l'a vu insuffisante pour changer cet état.

Au contraire, l'application de la tension de reprogrammation sur les cellules dans lesquelles on avait déjà formé un filament conducteur va reformer les filaments qui ont été partiellement défaits à l'issue du soudage, comme lors d'une opération de SET « 1 ». On retrouve alors l'état LRS à faible résistance et la préprogrammation est complètement restaurée. Les circuits de lecture peuvent à nouveau distinguer les niveaux « 1 » préprogrammés des niveaux « 0 ».

Les cellules mémoire qui lors de la programmation avant stress thermique ont été amenées à l'état SET « 1 » et qui le demeure suite au stress thermique présenteront également l'état LRS après l'application de la tension intermédiaire. Plus précisément, ces cellules mémoire subiront premièrement un RESET (le seuil de tension nécessaire à l'opération de RESET étant atteint), puis une opération de SET (la tension seuil pour le déroulement de cette opération de SET étant ensuite atteinte puisque la tension intermédiaire appliquée est supérieure à cette tension de SET). Ainsi, l'état résistif avant et après re-programmation est identique.

De manière optionnelle et avantageuse, on remarquera que les cellules préprogrammées à « 1 » avant application du stress thermique (correspondant typiquement à une étape de soudage) pourront l'être plusieurs fois en effectuant des cycles de RESET et de SET afin d'être sûr qu'elles sont bien fonctionnelles. Ces séquences d'opérations de SET et de RESET ont également pour but de stabiliser le filament conducteur qui est formé. Avantageusement, les cellules qui s'avéreraient alors être hors spécification, ayant par exemple des valeurs de SET particulièrement élevées ou dispersées, pourront être déclarées non fonctionnelles. Elles seront non utilisées et remplacées par d'autres cellules fonctionnelles. Leur contenu sera alors transféré en mettant en oeuvre les techniques de redondance développées pour d'autres types de mémoires comme celles dites FLASH qui peuvent fonctionner avec des cellules individuelles, des secteurs voire des pages non fonctionnels.

Les cellules qui n'auront pas été amenées dans l'état conducteur ou peu résistif (i.e., deuxième état résistif LRS) et qui conservent l'état résistif originel (HRS originel) ne feront pas l'objet de ces cycles d'opérations de SET et de RESET. Leur état non conducteur est donc conservé. On pourra néanmoins contrôler que ces cellules présentent effectivement un état à forte résistance.

La description qui précède décrit plus particulièrement des modes de réalisation dans lesquels l'étape d'assemblage est effectuée par soudage ou par brasage. L'invention s'étend également aux modes de réalisation dans lesquels l'assemblage du composant contenant la matrice de cellules mémoire sur un support est effectué par la méthode dite WLCSP (Wafer Level Chip Scale Packages).

Cette technique d'assemblage a été développée par l'industrie de la microélectronique pour permettre l'assemblage des composants constituant un système embarqué sur un ou plusieurs circuits imprimés. Cette technique repose sur le dépôt, sur le composant à assembler, d'une couche de matériau polymère photo-définissable par exemple un matériau polyimide, c'est-à-dire un matériau polymère contenant un ou plusieurs groupes imide dans sa chaine principale, ou le polybenzobisoxazole également appelé PBO. Ces matériaux étant photo-définissables, la couche ainsi déposée pourra être gravée par exposition à un stimulus lumineux approprié suivi par un développement. Une bille métallique peut alors être déposée dans la cavité tout juste obtenue. Cette bille est responsable des contacts mécanique et électriques entre le composant à assembler et le ou les circuit(s) imprimé(s) correspondant(s).

Dans certains cas, le dépôt de la bille métallique est remplacé par le dépôt d'une couche métallique, par exemple en Cuivre, appelée ReDistribution Layer ou RDL, qui est gravée. Cette couche RDL est alors encapsulée par un matériau polymère photo-définissable qui est à son tour gravé par exposition à un stimulus lumineux approprié et développement. Une bille métallique, responsable des contacts mécanique et électriques entre le composant à assembler et le ou les circuit(s) imprimé(s) correspondant(s), est alors déposée dans la cavité tout juste obtenue.

Dans certains cas, le dépôt de la bille métallique est précédé de l'obtention d'une couche métallique, appelée UBM pour Under Bump metallurgy, en Cuivre ou à base de Nickel (voir Figures ci-dessus).

Bien souvent, la couche ou les couches de matériau polymère doivent être obtenues en suivant un procédé incluant des étapes de recuit à haute température. Nous proposons ci-dessous un exemple des principales étapes nécessaires à l'obtention d'une couche de matériau polymère pouvant être utilisée lors des techniques d'assemblage décrites précédemment :
- Préparation du substrat : T° 80°C-200°C - Durée : 60-240 secondes (s)
- Recuit doux (soft bake) : T° 120°C - Durée : 180 s
- Cure sous Azote (HD8820) :
   ∘ Montée en température : 25°C -> 150°C avec une pente de 4°C/min
   ∘ Montée en température: 150°C -> 320°C avec une pente de 2,5°C/min
   ∘ Plateau de température: 320°C pendant 1 heure
   ∘ Retour graduel à température ambiante
Les indications ci-dessous concernent un autre exemple de cure sous Azote (HD-4100) :
∘ Montée en température : 25°C → 200°C avec une pente de 10°C/min
∘ Attente à 200°C pendant 30 min
∘ Montée en température : 200°C → 375°C avec une pente de 10°C/min
∘ Plateau de température: 375°C pendant 1 heure
∘ Retour graduel à température ambiante

Ainsi, ces procédés comprennent au moins une étape à une température comprise supérieure à 240°C, souvent supérieure à 300°C et le plus souvent entre 320°C et 375°C pour une durée de plusieurs dizaines de minutes, typiquement 60 minutes.

L'invention permet retrouver après cette étape à très haute température les données sauvegardées avant assemblage.

L'invention n'est pas limitée aux modes de réalisation précédemment décrits mais s'étend à tous les modes de réalisation couverts par la portée des revendications.

En particulier, bien que dans la description détaillée illustrant les figures on considère essentiellement le cas où avant assemblage les cellules sont soit dans l'état originel (HRS originel), soit dans le deuxième état résistif (LRS), l'invention couvre également les cas où avant assemblage les cellules sont amenées depuis le deuxième état résistif (LRS) jusqu'au troisième état résistif (HRS programmé).

En effet, selon les modes de réalisation, on choisira de modifier ou non, avant assemblage l'état résistif des cellules mémoire qui avaient été amenées dans le deuxième état résistif (LRS) depuis l'état résistif originel (HRS originel). Ainsi, ces cellules mémoire qui se trouvaient dans le deuxième état résistif (LRS) avant assemblage pourront, toujours avant assemblage, soit être toutes laissées dans le deuxième état résistif (LRS) soit être amenées dans le troisième état résistif (HRS programmé) par application d'une tension.

Le couple HRS originel/ LRS présente pour avantage de ne nécessiter qu'une seule programmation des cellules.

## Revendications

1. Procédé de préprogrammation d'une matrice (300) de cellules mémoire résistives non volatiles, lesdites cellules mémoire (310, 320) comprenant un matériau diélectrique (110) disposé entre deux électrodes conductrices (120, 130), lesdites cellules mémoire (310, 320) étant initialement dans un état résistif originel (HRS originel) correspondant à un premier état résistif et le matériau diélectrique (110) étant apte à être modifié électriquement de manière à amener la cellule mémoire depuis l'état résistif originel (HRS originel) jusqu'à au moins un autre état résistif (LRS, HRS programmé) dans lequel la résistance de la cellule mémoire est au moins deux fois inférieure à la résistance de la cellule mémoire dans l'état résistif originel (HRS originel), le procédé comprenant les étapes suivantes:
avant assemblage d'un composant contenant ladite matrice avec un support : programmer la matrice en amenant électriquement une pluralité de cellules (320) depuis l'état résistif originel (HRS originel) jusqu'audit autre état résistif (LRS, HRS programmé) ;
laisser les autres cellules mémoires (310) dans leur état résistif originel (HRS originel);
**caractérisé en ce que** le procédé comprend l'étape suivante, après l'assemblage du composant contenant ladite matrice avec le support:
appliquer sur toutes les cellules (310, 320) de la matrice une tension intermédiaire (212), ladite tension intermédiaire (212) étant :
- inférieure à une première plage de tensions (230) de valeurs suffisamment élevées pour pouvoir amener une cellule mémoire (310, 320) depuis l'état résistif originel (HRS originel) jusqu'à un deuxième état résistif (LRS) dans lequel la résistance de la cellule mémoire est au moins deux fois inférieure à la résistance de la cellule mémoire dans l'état résistif originel (HRS originel), la tension intermédiaire (212) étant insuffisante pour modifier l'état résistif des cellules (310) qui avaient été laissées dans leur état résistif originel (HRS originel) par l'étape de programmation réalisée avant l'assemblage;
- supérieure à une deuxième plage de tensions (220) de valeurs inférieures à la première plage (230) mais suffisamment élevées pour pouvoir amener une cellule mémoire (310, 320) qui n'est pas dans l'état résistif originel (HRS originel) jusqu'audit deuxième état résistif (LRS),
les première (230) et deuxième (220) plages de tensions étant disjointes.

2. Procédé selon la revendication précédente dans lequel les première et deuxième plages de tensions sont séparées par un intervalle (210) intermédiaire de valeurs, ledit intervalle (210) intermédiaire de valeurs étant supérieur ou égal à 100 millivolts.

3. Procédé selon l'une quelconque des revendications précédentes dans lequel au cours de l'étape d'assemblage les cellules mémoire sont soumises à une température d'au moins 240°C de préférence pendant au moins 10 secondes.

4. Procédé selon l'une quelconque des revendications précédentes dans lequel l'étape d'assemblage comprend une étape de brasage ou de soudage du composant sur le support ou une étape d'assemblage par la technique dite de réalisation d'un boitier à la taille d'une puce au niveau du substrat (WLCSP).

5. Procédé selon l'une quelconque des revendications précédentes dans lequel l'étape d'assemblage du composant contenant ladite matrice avec le support comprend l'assemblage du composant sur une carte imprimée, une carte électronique, un autre composant électronique ou un boîtier.

6. Procédé selon l'une quelconque des revendications précédentes dans lequel ledit deuxième état résistif (LRS) est directement obtenu par application d'une tension depuis l'état résistif originel (HRS originel).

7. Procédé selon la revendication précédente dans lequel ledit autre état résistif (LRS, HRS programmé) est ledit deuxième état résistif (LRS).

8. Procédé selon la revendication 6 dans lequel ledit autre état résistif (LRS, HRS programmé) est un troisième état résistif (HRS programmé) dans lequel la résistance de la cellule mémoire est au moins deux fois inférieure à la résistance de la cellule mémoire dans l'état résistif originel (HRS originel), dans lequel la résistance de la cellule mémoire présente une résistance différente de celle de la cellule mémoire dans le deuxième état résistif (LRS) et dans lequel amener électriquement une cellule mémoire depuis l'état résistif originel (HRS originel) jusqu'au troisième état résistif (HRS programmé) comprend les étapes suivantes effectuées avant assemblage :
- appliquer une tension à la cellule mémoire de manière à amener la cellule mémoire depuis l'état résistif originel (HRS originel) jusqu'audit deuxième état résistif (LRS) ;
- appliquer une tension à la cellule de manière à amener la cellule mémoire depuis le deuxième état résistif (LRS) jusqu'au troisième état résistif (HRS programmé).

9. Procédé selon la revendication précédente dans lequel, dans le troisième état résistif (HRS programmé) la cellule mémoire présente une résistance supérieure à celle de la cellule mémoire dans le deuxième état résistif (LRS) de manière à ce qu'un circuit de lecture puisse identifier si la cellule est dans le deuxième état résistif (LRS) ou dans le troisième état résistif (HRS programmé) et dans lequel, dans le troisième état résistif (HRS programmé) la cellule mémoire présente une résistance supérieure d'au moins un facteur 2, à la résistance de la cellule mémoire dans le deuxième état résistif (LRS) et de préférence d'au moins un facteur 10.

10. Procédé selon l'une quelconque des revendications précédentes dans lequel après l'étape de programmation et avant l'assemblage, les cellules de ladite pluralité de cellules (320) sont dans le deuxième état résistif (LRS) ou sont dans un troisième état résistif (HRS programmé) dans lequel la résistance de la cellule mémoire est au moins deux fois inférieure à la résistance de la cellule mémoire dans l'état résistif originel (HRS originel) et dans lequel on effectue au moins un cycle d'étapes sur lesdites cellules de ladite pluralité de cellules (320) amenées à l'autre état résistif (LRS, HRS programmé), chaque cycle consistant à amener électriquement lesdites cellules de ladite pluralité de cellules (320) depuis un état souhaité parmi le deuxième état résistif (LRS) et le troisième état résistif (HRS programmé) vers l'autre parmi ces deux états puis à ramener lesdites cellules à l'état souhaité.

11. Procédé selon la revendication précédente dans lequel on effectue plusieurs cycles d'étapes.

12. Procédé selon l'une quelconque des deux revendications précédentes dans lequel au terme d'au moins un cycle d'étapes on vérifie que les cellules de ladite pluralité de cellules (320) sont dans l'état souhaité, et on identifie, parmi les cellules de ladite pluralité de cellules (320), celles qui ne sont pas dans l'état souhaité et dans lequel de préférence on transfert le contenu desdites cellules identifiées à d'autres cellules mémoire.

13. Procédé selon l'une quelconque des revendications précédentes dans lequel on prévoit pour la matrice un nombre de cellules mémoire supérieur à celui nécessaire à l'information que l'on souhaite stocker, définissant ainsi des cellules mémoire test non destinées à contenir de l'information à stocker et on effectue, préalablement à la programmation, des tests sur lesdites cellules mémoire test de manière à déterminer les première (230) et deuxième (220) plages de tensions.

14. Procédé selon l'une quelconque des revendications précédentes dans lequel tout le courant passant entre les deux électrodes conductrices (120, 130) traverse le matériau diélectrique (110) et dans lequel le matériau diélectrique (110) est de préférence au contact de chacune des deux électrodes conductrices (120, 130).

15. Procédé selon l'une quelconque des revendications précédentes dans lequel le matériau diélectrique (110) est un oxyde, la cellule mémoire étant de type OxRAM.

## Patentansprüche

1. Verfahren zum Vorprogrammieren einer Matrix (300) von nicht flüchtigen, resistiven Speicherzellen, wobei die Speicherzellen (310, 320) ein dielektrisches Materials (110) enthalten, das zwischen zwei leitfähigen Elektroden (120, 130) angeordnet ist, wobei die Speicherzellen (310, 320) anfänglich in einem ursprünglichen resistiven Zustand (Ursprünglicher HRS) sind, der einem ersten resistiven Zustand entspricht, und wobei das dielektrische Material (110) dazu geeignet ist, elektrisch so modifiziert zu werden, dass die Speicherzelle von dem ursprünglichen resistiven Zustand (ursprünglicher HRS) in zumindest einen anderen resistiven Zustand (LRS, programmierter HRS) gebracht wird, in welchem der Widerstand der Speicherzelle höchstens halb so hoch wie der Widerstand der Speicherzelle im ursprünglichen resistiven Zustand (ursprünglicher HRS) ist, wobei das Verfahren die nachfolgenden Schritte umfasst:
vor dem Zusammenfügen einer Komponente, welche die Matrix beinhaltet, mit einem Träger: Programmieren der Matrix, indem eine Mehrzahl von Zellen (320) elektrisch von dem ursprünglichen resistiven Zustand (ursprünglicher HRS) in den anderen resistiven Zustand (LRS, programmierter HRS) gebracht wird; Belassen der weiteren Speicherzellen (310) in ihrem ursprünglichen resistiven Zustand (ursprünglicher HRS);
**dadurch gekennzeichnet, dass** das Verfahren den nachfolgenden Schritt nach dem Zusammenfügen der die Matrix beinhaltenden Komponente mit dem Träger umfasst:
Anlegen einer Zwischenspannung (212) an sämtliche Zellen (310, 320) der Matrix, wobei die Zwischenspannung (212)
- geringer als ein erster Spannungsbereich (230) von Werten ist, die ausreichend hoch sind, um eine Speicherzelle (310, 320) von dem ursprünglichen resistiven Zustand (ursprünglicher HRS) in einen zweiten resistiven Zustand (LRS) bringen zu können, in welchem der Widerstand der Speicherzelle höchstens halb so hoch wie der Widerstand der Speicherzelle in dem ursprünglichen resistiven Zustand (ursprünglicher HRS) ist, wobei die Zwischenspannung (212) nicht ausreicht, um den resistiven Zustand der Zellen (310) zu modifizieren, die in ihrem ursprünglichen resistiven Zustand (ursprünglicher HRS) belassen wurden, und zwar durch den vor dem Zusammenfügen erfolgenden Schritt des Programmierens;
- höher als ein zweiter Spannungsbereich (220) von Werten ist, die geringer als beim ersten Bereich (230), jedoch ausreichend hoch sind, um eine Speicherzelle (310, 320), die nicht im ursprünglichen resistiven Zustand (ursprünglicher HRS) ist, in den zweiten resistiven Zustand (LRS) bringen zu können,
wobei der erste (230) und der zweite (220) Spannungsbereich getrennt sind.

2. Verfahren nach dem vorangehenden Anspruch, wobei der erste und der zweite Spannungsbereich durch ein Zwischenintervall (210) von Werten getrennt sind, wobei das Zwischenintervall (210) von Werten größer oder gleich 100 Millivolt ist.

3. Verfahren nach einem der vorangehenden Ansprüche, wobei beim Schritt des Zusammenfügens die Speicherzellen einer Temperatur von zumindest 240 °C und vorzugsweise zumindest 10 Sekunden lang ausgesetzt werden.

4. Verfahren nach einem der vorangehenden Ansprüche, wobei der Schritt des Zusammenfügens einen Schritt des Verlötens bzw. Verschweißens der Komponente mit dem Träger oder einen Schritt des Zusammenfügens durch die sogenannte Technik zum Herstellen eines Gehäuses in der Größenordnung eines Chips im Bereich des Substrats (WLCSP) umfasst.

5. Verfahren nach einem der vorangehenden Ansprüche, wobei der Schritt des Zusammenfügens der die Matrix beinhaltenden Komponente mit dem Träger das Anfügen der Komponente an eine Leiterplatte, eine elektronische Karte, eine weitere elektronische Komponente oder ein Gehäuse umfasst.

6. Verfahren nach einem der vorangehenden Ansprüche, wobei der zweite resistive Zustand (LRS) unmittelbar durch Anlegen einer Spannung von dem ursprünglichen resistiven Zustand (ursprünglicher HRS) erhalten wird.

7. Verfahren nach dem vorangehenden Anspruch, wobei der andere resistive Zustand (LRS, programmierter HRS) der zweite resistive Zustand (LRS) ist.

8. Verfahren nach Anspruch 6, wobei der andere resistive Zustand (LRS, programmierter HRS) ein dritter resistiver Zustand (programmierter HRS) ist, in welchem der Widerstand der Speicherzelle höchstens halb so hoch wie der Widerstand der Speicherzelle im ursprünglichen resistiven Zustand (ursprünglicher HRS) ist, wobei der Widerstand der Speicherzelle einen anderen Widerstand als die Speicherzelle in dem zweiten resistiven Zustand (LRS) aufweist und wobei das elektrische Verbringen einer Speicherzelle von dem ursprünglichen resistiven Zustand (ursprünglicher HRS) in den dritten resistiven Zustand (programmierter HRS) die nachstehenden Schritte umfasst, die vor dem Zusammenfügen erfolgen:
- Anlegen einer Spannung an die Speicherzelle derart, dass die Speicherzelle von dem ursprünglichen resistiven Zustand (ursprünglicher HRS) in den zweiten resistiven Zustand (LRS) gebracht wird;
- Anlegen einer Spannung an die Speicherzelle derart, dass die Speicherzelle von dem zweiten resistiven Zustand (LRS) in den dritten resistiven Zustand (programmierter HRS) gebracht wird.

9. Verfahren nach dem vorangehenden Anspruch, wobei in dem dritten resistiven Zustand (programmierter HRS) die Speicherzelle einen Widerstand aufweist, der höher als der der Speicherzelle in dem zweiten resistiven Zustand (LRS) ist, so dass eine Ausleseschaltung identifizieren kann, ob die Zelle in dem zweiten resistiven Zustand (LRS) oder in dem dritten resistiven Zustand (programmierter HRS) ist, und wobei in dem dritten resistiven Zustand (programmierter HRS) die Speicherzelle einen Widerstand aufweist, der zumindest um einen Faktor 2 und vorzugsweise zumindest um einen Faktor 10 höher als der Widerstand der Speicherzelle in dem zweiten resistiven Zustand (LRS) ist.

10. Verfahren nach einem der vorangehenden Ansprüche, wobei nach dem Schritt des Programmierens und vor dem Zusammenfügen die Zellen der Mehrzahl von Zellen (320) in dem zweiten resistiven Zustand (LRS) sind oder in einem dritten resistiven Zustand (programmierter HRS), in welchem der Widerstand der Speicherzelle höchstens halb so hoch wie der Widerstand der Speicherzelle in dem ursprünglichen resistiven Zustand (ursprünglicher HRS) ist, und wobei zumindest ein Zyklus von Schritten an den in den anderen resistiven Zustand (LRS, programmierter HRS) gebrachten Zellen der Mehrzahl von Zellen (320) erfolgt, wobei jeder Zyklus darin besteht, die Zellen der Mehrzahl von Zellen (320) elektrisch von einem gewünschten Zustand aus zweitem resistiven Zustand (LRS) und drittem resistiven Zustand (programmierter HRS) in den anderen dieser beiden Zustände zu bringen, dann die Zellen wieder in den gewünschten Zustand zu bringen.

11. Verfahren nach dem vorangehenden Anspruch, wobei mehrere Zyklen von Schritten erfolgen.

12. Verfahren nach einem der beiden vorangehenden Ansprüche, wobei am Ende zumindest eines Zyklus von Schritten überprüft wird, dass die Zellen der Mehrzahl von Zellen (320) in dem gewünschten Zustand sind und aus den Zellen der Mehrzahl von Zellen (320) diejenigen identifiziert werden, die nicht in dem gewünschten Zustand sind, und wobei vorzugsweise der Inhalt der identifizierten Zellen auf andere Speicherzellen übertragen wird.

13. Verfahren nach einem der vorangehenden Ansprüche, wobei für die Matrix eine Anzahl von Speicherzellen vorgesehen wird, die höher als diejenige ist, die für die abzuspeichernde Information erforderlich ist, wodurch somit Test-Speicherzellen definiert werden, die nicht dazu bestimmt sind, die abzuspeichernde Information zu enthalten, und vor dem Programmieren Tests an den Test-Speicherzellen durchgeführt werden, so dass der erste (230) und der zweite (220) Spannungsbereich bestimmt werden.

14. Verfahren nach einem der vorangehenden Ansprüche, wobei der gesamte Strom, der zwischen den beiden leitfähigen Elektroden (120, 130) durchtritt, durch das dielektrische Material (110) hindurchfließt, und wobei das dielektrische Material (110) vorzugsweise mit jeder der beiden leitfähigen Elektroden (120, 130) in Kontakt steht.

15. Verfahren nach einem der vorangehenden Ansprüche, wobei das dielektrische Material (110) ein Oxid ist, wobei die Speicherzelle vom Typ OxRAM ist.

## Claims

1. Method for pre-programming a matrix (300) of non-volatile resistive memory cells, said memory cells (310, 320) comprising a dielectric material (110) arranged between two conductive electrodes (120, 130), said memory cells (310, 320) being initially in an original resistive state (original HRS) corresponding to a first resistive state and the dielectric material (110) being capable of being electrically modified so as to bring the memory cell from the original resistive state (original HRS) up to at least another resistive state (LRS, programmed HRS) wherein the resistance of the memory cell is at least twice less than the resistance of the memory cell in the original resistive state (original HRS), the method comprising the following steps:
before assembly of a component containing said matrix with a support: programming the matrix by electrically bringing a plurality of cells (320) from the original resistive state (original HRS) up to said other resistive state (LRS, programmed HRS); leaving the other memory cells (310) in the original resistive state thereof (original HRS);
**characterised in that** the method comprises the following step, after assembly of the component containing said matrix with the support:
applying on all the cells (310, 320) of the matrix, an intermediate voltage (212), said intermediate voltage (212) being:
- less than a first range of voltages (230) of sufficiently increased values to be able to bring a memory cell (310, 320) from the original resistive state (original HRS) up to a second resistive state (LRS) wherein the resistance of the memory cell is at least two less than the resistance of the memory cell in the original resistive state (original HRS), the intermediate voltage (212) being insufficient to modify the resistive state of the cells (310) which had been left in the original resistive state thereof (original HRS) by the programming step carried out before assembly;
- greater than a second range of voltages (220) of values less than the first range (230) but sufficiently increased to be able to bring a memory cell (310, 320) which is not in the original resistive state (original HRS) up to said second resistive state (LRS), the first (230) and second (220) ranges of voltages being separate.

2. Method according to the preceding claim, wherein the first and second ranges of voltages are separated by an intermediate interval (210) of values, said intermediate interval (210) of values being greater than or equal to 100 millivolts.

3. Method according to any one of the preceding claims, wherein during the step of assembling the memory cells, are subjected to a temperature of at least 240°C, preferably for at least 10 seconds.

4. Method according to any one of the preceding claims, wherein the assembly step comprises a step of soldering or welding the component on the support or an assembly step by the technique called producing a wafer level chip scale packing (WLCSP).

5. Method according to any one of the preceding claims, wherein the step of assembling the component containing said matrix with the support comprises the assembly of the component on a printed board, an electronic board, another electronic component or a packing.

6. Method according to any one of the preceding claims, wherein said second resistive state (LRS) is directly obtained by application of a voltage from the original resistive state (original HRS).

7. Method according to the preceding claim, wherein said other resistive state (LRS, programmed HRS) is said second resistive state (LRS).

8. Method according to claim 6, wherein said other resistive state (LRS, programmed HRS) is a third resistive state (programmed HRS), wherein the resistance of the memory cell is at least twice less than the resistance of the memory cell in the original resistive state (original HRS), wherein the resistance of the memory cell has a resistance, different from that of the memory cell in the second resistive state (LRS) and wherein, electrically bringing a memory cell from the original resistive state (original HRS) up to the third resistive state (programmed HRS) comprises the following steps carried out before assembly:
- applying a voltage to the memory cell so as to bring the memory cell from the original resistive state (original HRS) up to said second resistive state (LRS);
- applying a voltage to the cell so as to bring the memory cell from the second resistive state (LRS) up to the third resistive state (programmed HRS).

9. Method according to the preceding claim, wherein in the third resistive state (programmed HRS), the memory cell has a resistance greater than that of the memory cell in the second resistive state (LRS) such that a read circuit can identify if the cell is in the second resistive state (LRS) or in the third resistive state (programmed HRS) and wherein, in the third resistive state (programmed HRS), the memory cell has a resistance greater than at least a factor 2, to the resistance of the memory cell in the second resistive state (LRS) and preferably at least a factor 10.

10. Method according to any one of the preceding claims, wherein after the programming step and before assembly, the cells of said plurality of cells (320) are in the second resistive state (LRS) or are in a third resistive state (programmed HRS), wherein the resistance of the memory cell is at least twice less than the resistance of the memory cell in the original resistive state (original HRS), and wherein at least one cycle of steps on said cells of said plurality of cells (320) brought to another resistive state (LRS, programmed HRS) is made, each cycle consisting of electrically bringing said cells of said plurality of cells (320) from a desired state from among the second resistive state (LRS) and the third resistive state (programmed HRS) towards the other from among these two states then to return said cells to the desired state.

11. Method according to the preceding claim, wherein a plurality of cycles of steps is carried out.

12. Method according to any one of the two preceding claims, wherein at the end of at least one cycle of steps, it is verified that the cells of said plurality of cells (320) are in the desired state, from among the cells of said plurality of cells (320), those which are not in the desired state and wherein preferably the content of said identified cells is transferred to other memory cells.

13. Method according to any one of the preceding claims, wherein for the matrix, a number of memory cells greater than that necessary for the information that is desired to be stored is provided, thus defining the test memory cells, not configured to contain information to be stored, and prior to programming, tests are carried out on said test memory cells so as to determine the first (230) and second (220) ranges of voltages.

14. Method according to any one of the preceding claims, wherein the whole current passing between the two conductive electrodes (120, 130) passes through the dielectric material (110), and wherein the dielectric material (110) is preferably in contact with each of the two conductive electrodes (120, 130).

15. Method according to any one of the preceding claims, wherein the dielectric material (110) is an oxide, the memory cell being of OxRAM type.
